Europäisches Patentamt

European Patent Office

Office européen des brevets

(19)

(11) **EP 1 051 634 B1**

(12) **EUROPÄISCHE PATENTSCHRIFT**

(45) Veröffentlichungstag und Bekanntmachung des Hinweises auf die Patenterteilung:
**31.08.2005 Patentblatt 2005/35**

(21) Anmeldenummer: **99907256.4**

(22) Anmeldetag: **20.01.1999**

(51) Int Cl.$^7$: **G01R 33/00**

(86) Internationale Anmeldenummer:
**PCT/DE1999/000126**

(87) Internationale Veröffentlichungsnummer:
**WO 1999/038025 (29.07.1999 Gazette 1999/30)**

(54) **COMPUTER ZUR AUSWERTUNG VON SIGNALEN AUS DER KERNMAGNETISCHEN RESONANZTOMOGRAPHIE SOWIE MIT DEM COMPUTER AUSGESTATTETER KERNRESONANZTOMOGRAPH**

COMPUTER FOR EVALUATING SIGNALS FROM NUCLEAR MAGNETIC RESONANCE TOMOGRAPHY, AND A NUCLEAR RESONANCE TOMOGRAPH EQUIPPED WITH SAID COMPUTER

ORDINATEUR POUR EVALUER DES SIGNAUX ISSUS DE TOMOGRAPHIE A RESONANCE MAGNETIQUE NUCLEAIRE ET TOMOGRAPHE A RESONANCE MAGNETIQUE NUCLEAIRE EQUIPE DUDIT ORDINATEUR

(84) Benannte Vertragsstaaten:
**AT BE CH CY DE DK ES FI FR GB GR IE IT LI LU MC NL PT SE**

(30) Priorität: **23.01.1998 DE 19802337**

(43) Veröffentlichungstag der Anmeldung:
**15.11.2000 Patentblatt 2000/46**

(73) Patentinhaber: **FORSCHUNGSZENTRUM JÜLICH GMBH**
**52425 Jülich (DE)**

(72) Erfinder:
- **GEMBRIS, Daniel**
  **D-44265 Dortmund (DE)**
- **POSSE, Stefan**
  **Grosse Pointe Park, MI 48230 (US)**
- **TAYLOR, John**
  **London SW13 0DS (GB)**

(56) Entgegenhaltungen:
- COX R W ET AL: "REAL-TIME FUNCTIONAL MAGNETIC RESONANCE IMAGING" MAGNETIC RESONANCE IN MEDICINE, Bd. 33, Nr. 2, 1. Februar 1995 (1995-02-01), Seiten 230-236, XP000482947 ISSN: 0740-3194 in der Anmeldung erwähnt

- BANDETTINI P A: "PROCESSING STRATEGIES FOR TIME-COURSE DATA SETS IN FUNCTIONAL MRI OF THE HUMAN BRAIN" MAGNETIC RESONANCE IN MEDICINE, Bd. 30, Nr. 2, 1. August 1993 (1993-08-01), Seiten 161-173, XP000385350 ISSN: 0740-3194
- ZHANG R ET AL: "THE EFFECT OF MAGNETIZATION TRANSFER ON FUNCTIONAL MRI SIGNALS" MAGNETIC RESONANCE IN MEDICINE, Bd. 38, Nr. 2, 1. August 1997 (1997-08-01), Seiten 187-192, XP000695501 ISSN: 0740-3194
- M. SINGH ET AL : "Separation of veins from activated brain tissue in functional magnetic resonance images" NUCLEAR SCIENCE SYMPOSIUM AND MEDICAL IMAGING CONFERENCE, IEEE PRESS, Bd. 4, 30. Oktober 1994 (1994-10-30) - 5. November 1994 (1994-11-05), Seiten 1534-1536, XP002113480 Norfolk, VA, USA
- A.L. PARADIS ET AL : "Detection of Periodic Signals in Brain Echo-Planar Functional Images" 18TH ANNUAL INTERNATIONAL CONFERENCE OF THE IEEE/EMBS, IEEE PRESS, [Online] Bd. 2, 31. Oktober 1996 (1996-10-31) - 3. November 1996 (1996-11-03), Seiten 696-697, XP002113481 Amsterdam, NL Retrieved from the Internet: <URL:http://iel.ils.com> [retrieved on 1999-08-26]

• **G.Z. YANG ET AL : "In vivo blood flow visualization with magnetic resonance imaging" PROCEEDINGS OF VISUALIZATION WITH MAGNETIC RESONANCE IMAGING, IEEE PRESS, [Online] 22. - 25. Oktober 1991, Seiten 202-209, XP002113482 San Diego, CA, USA Retrieved from the Internet: <URL:http://iel.ils.com> [retrieved on 1999-08-26]**

**Beschreibung**

Die Erfindung betrifft einen Computer zur Auswertung von Signalen aus der kernmmagnetischen Resonanztomographie sowie einen mit dem Computer ausgestatteten Kernresonanztomographen.

In der medizinischen Forschung besteht das Bedürfnis, Informationen über die Gehirnaktivität oder im weiteren Sinne Informationen über Blutfluß oder Deoxyhämoglobinkonzentrationsänderungen in tierischen und menschlichen Organen zu erlangen. Die neuronale Aktivierung äußert sich in einer Zunahme des Blutflusses in aktivierten Gerhirnarealen, wobei es zu einer Abnahme der Blut-Deoxyhämoglobinkonzentration kommt. Deoxyhämoglobin (DOH) ist ein paramagnetischer Stoff, welcher die Kernspin-Dephasierung beschleunigt. Sinkt die DOH-Konzentration aufgrund einer einen Blutfluß auslösenden Gehirnaktivität, so reduziert sich der dämpfende Effekt auf die NMR-Strahlung in den aktiven Arealen des Gehirns, so daß NMR-Signale (Kernmagnetische-Resonanzsignale) des sich im Gehirn befindenden Wassers eine höhere Intensität erlangen. Angeregt werden in erster Linie die Protonen des Wasserstoffes im Wasser. DOH wirkt somit dämpfend auf die NMR-Strahlung, welches bedingt durch Gehirnaktivität entzogen wird und somit eine Lokalisierung von Gehirnaktivität erlaubt, wenn eine Untersuchung mit NMR-Methoden angewendet wird. Dieser Wirkmechanismus ist in der Literatur unter dem Namen BOLD-Effekt (Blood Oxygen Level Dependent - Effekt) bekannt und führt bei suszeptibilitätsempfindlichen magnetischen Resonanzmessungen bei einer Feldstärke eines statischen Magnetfeldes von zum Beispiel 1,5 Tesla bis zu ca. 10%igen Schwankungen der Bildhelligkeit in aktivierten Hirnregionen. Anstelle des endogenen Kontrastmittels DOH können auch andere Kontrastmittel treten, die eine Änderung in der Suszeptibilität hervorrufen. Durch NMR-Bildgebungsmethoden werden Schichten oder Volumina selektiert, die unter dem geeigneten Einstrahlen von Hochfrequenzpulsen und dem Anlegen von magnetischen Gradientenfeldern ein Meßsignal liefern, welches digitalisiert und in einem zwei- oder dreidimensionalen Feld im Meßcomputer gespeichert wird.

Aus den aufgenommenen Rohdaten wird durch eine zwei- oder dreidimensionale Fourier-Transformation die gewünschte Bildinformation gewonnen (rekonstruiert).

Ein rekonstruiertes Schichtbild besteht aus Pixeln, ein Volumendatensatz aus Voxeln. Ein Pixel ist ein zweidimensionales Bildelement, beispielswseise ein Quadrat, aus denen das Bild zusammengesetzt ist. Ein Voxel ist ein dreidimensionales Volumenelement, beispielsweise ein Quader, der meßtechnisch bedingt keine scharfe Grenze aufweist. Die Abmessungen eines Pixels liegen in der Größenordnung von $1mm^2$ die eines Voxels von $1mm^3$. Die Geometrien und Ausdehnungen können variabel sein.

Da aus experimentellen Gründen bei Schichtbildern niemals von einer streng zweidimensionalen Ebene ausgegangen werden kann, wird häufig auch hier der Begriff Voxel (= Volume element = Volumenelement) verwendet, welcher berücksichtigt, daß die Bildebenen eine Eindringtiefe in die dritte Dimension haben.

Durch Vergleich des gemessenen Signalverlaufs in jedem - Pixel mit dem zeitlichen Verlauf einer Modellfunktion, kann eine Stimulus-spezifische neuronale Aktivierung detektiert und räumlich lokalisiert werden. Ein Stimulus kann zum Beispiel ein somatosensorischer, akustischer, visueller oder olfaktorischer Reiz sowie eine mentale oder motorische Aufgabe sein. Die Modellfunktion bzw. die Modell-Zeitreihe beschreibt die erwartete Signaländerung des magnetischen Resonanzsignals infolge neuronaler Aktivierung. Diese können zum Beispiel mittels empirischer Regeln aus dem Paradigma des jeweiligen Experiments abgeleitet werden. Wesentlich ist es, eine zeitliche Verzögerung der Modellfunktion gegenüber dem Paradigma zu berücksichtigen (träge Reaktion des Blutflusses auf neuronale Aktivierung).

Es ist bereits bekannt, wie Gehirnaktivierung durch Bilder dargestellt werden kann, die aus kernspintomographischen Daten gewonnen wurden. Die Berechnung und Wiedergabe der Aktivierungsbilder ist sogar in Echtzeit möglich, das heißt, ein Datensatz kann in ein Bild umgesetzt werden, bevor der nächste Datensatz gemessen wird. Der zeitliche Abstand beträgt dabei typischerweise 1 bis 3 Sekunden.

Die am weitesten verbreitete Methode zur Detektion neuronaler Aktivität ist die Korrelationsanalyse. Sie wird durch die Berechnung der Kreuzkorrelationskoeffizienten zwischen einem Referenzvektor, also einer Modell-Zeitreihe, und den Zeitreihen der betrachteten Voxels realisiert. Die Echtzeittauglichkeit eines Korrelationsalgorithmus erfordert, daß die für die Neuberechnung der Korrelationskoeffizienten benötigte Zeit konstant ist für jeden neu aufgenommenen Magnet-Resonanzdatensatz.

Eine Echtzeit-Korrelationsanalyse ist von Cox,R.W., Jesmanowicz, A., Hyde, J.S. Magn. Reson. Med., 33, 230, 1995 bekannt, die die Unterdrückung von Stör-Signalen mittels eines Detrending-Verfahrens unterstützt. Bei einem Detrending-Verfahren wird der Versuch unternommen, den Effekt von nicht-Stimulus induzierten Signaländerungen in den gemessenen Zeitreihen zu reduzieren. Mathematisch heißt das, daß der Meßvektor, also der Vektor, der die gemessene Zeitreihe eines Voxels beinhaltet, in die Summe zweier orthogonaler Vektoren aufgespalten wird. Der Anteil, der durch eine Linearkombination von Detrending-Vektoren beschrieben wird, wird verworfen. Die Detrending-Vektoren, die mathematisch gesehen eine Basis bilden, beinhalten die Zeitreihen, aus deren gewichteter Summe der Gesamtstöranteil der gemessenen Zeitreihen beschrieben wird. Durch Anwendung von Detrending auf die in die Korrelationsberechnung eingehenden Meß- und Referenzvektoren kann der Effekt von nicht-Stimulus induzierten Signaländerungen auf die Korrelationsbilder reduziert werden.

Bei Anwendung von Detrending berechnen sich die Korrelationskoeffizienten $\rho$ gemäß Formel (1).

$$\rho = \frac{\vec{x}_S \vec{r}_S}{|\vec{x}_S||\vec{r}_S|} \tag{1}$$

Hierin sind:

$\rho$ = Korrelationskoeffizient
$\vec{x}_s$ = Meßvektor nach Detrending
$\vec{r}_s$ = Referenzvektor nach Detrending

Weiterhin wurde von Cox, R.W., Comput. Biomed. Res. 29, 162, 1996 das Progamm AFNI vorgestellt, das auf dem Algorithmus der erstgenannten Veröffentlichung basiert. Der bekannte Algorithmus basiert auf Elementen einer Matrix, die sich durch Cholesky-Zerlegung einer anderen Matrix ergibt, die sich aus den Skalarprodukten des Meß- und Referenzvektors sowie der Detrendingvektoren zusammensetzt.

Die bei einer kernspintomographischen Untersuchung gemessene neuronale Aktivierung folgt dem Stimulationsparadigma, also dem Protokoll, daß den zeitlichen Ablauf der Stimuli wiedergibt. Üblicherweise wird eine Ein-Ausperiode (d.h. ein Wechsel von Stimulus ein, Stimulus aus) mehrfach wiederholt. Wenn eine Korrelationsanalyse alle Meßzeitpunkte berücksichtigt, nimmt die Empfindlichkeit für Änderungen der Signal-Response-Form mit jedem Aktivierungszyklus ab.

Die Methoden nach dem Stand der Technik ermöglichen jedoch keine gleichbleibende Sensitivität für die Änderung der Signal-Response-Form.

Es ist daher die Aufgabe der Erfindung, einen Computer und einen Kernmagnetischen Resonanztomographen zu schaffen, die bessere Auswertungsergebnisse ermöglichen. Insbesondere soll eine gleichbleibende Sensitivität für die Änderung der Signal-Response-Form erreicht werden und weiterhin soll ein Computer und ein kernmagnetischer Resonanztomograph geschaffen werden, welche derart arbeiten, daß sie die Vorraussetzungen für die Implementierung einer derartigen Lösung erst ermöglichen. Hierzu soll ein neues Detrending-Verfahren zur Reduktion von Störanteilen in den gemessenen Signalen entwickelt werden, das die Implementierung ermöglicht.

Erfindungsgemäß wird durch Kombination der Gleichungen (1),(4) und (5) die Vorrausetzung für die gleichbleibende Sensitivität für die Änderung der Signal-Response-Form erreicht.

Demnach werden gemäß Formel (2) und (3) in einem ersten Schritt die Vektoren $\vec{\gamma}$ und $\vec{\delta}$ berechnet, die sich aus den Detrending-Koeffizienteh $\gamma_i$ bzw. $\delta_i$ ($\vec{\gamma} = (\gamma_0, \gamma_1..)^T$, $\vec{\delta} = (\delta_0, \delta_1...)^T$ zusammensetzen. Die Herleitung der Gleichungen erfolgt durch die Minimierung zweier quadratischer Formen. Die Detrending-Matrix S beinhaltet $s_i$ als Spaltenvektoren.

$$(S^T S)\vec{\gamma} = S^T \vec{X} \tag{2}$$

$$(S^T S)\vec{\delta} = S^T \vec{r} \tag{3}$$

Hierin sind:

S = Detrending-Matrix mit $\vec{s}_i$ als Spaltenvektoren
$S^T$ = Transponierte von S (Matrix wird an ihrer Diagonalen gespiegelt)
$\vec{x}$ = Meßvektor; beinhaltet die gemessene Zeitreihe eines Voxels.
$\vec{r}$ = Referenzvektor; beinhaltet die Modell-Zeitreihe.
T = Symbol für Transposition von Matrizen.
$\vec{\gamma}$ = Vektor, der die Koeffizienten der Detrending-Vektoren für die Berechnung von $\vec{x}_s$ beinhaltet
$\vec{\delta}$ = Vektor, die die Koeffizienten der Detrending-Vektoren für die Berechnung von $\vec{r}_s$ beinhaltet

Diese linearen Gleichungssysteme werden rechnerisch effizient zum Beispiel durch die Methode der konjugierten Gradienten gelöst, falls der Referenzvektor räumlich variiert, oder anderenfalls am einfachsten durch Multiplikation mit der inversen Matrix, die wiederum mittels der konjugierten Gradienten-Methode bestimmt werden kann. Andere, weniger effiziente Methoden sind auch anwendbar. Es ist möglich, die erweiterte Korrelationsgleichung soweit umzuformen, bis nur noch iterativ berechenbare Terme übrigbleiben. Somit können die Korrelationskoeffizienten selbst iterativ berechnet werden.

In einem zweiten Schritt werden die Ausdrücke für $\vec{x}_s$ und $\vec{r}_s$ gemäß den Formeln (4) und (5) in Formel (1) substituiert.

$$\vec{x}_S \;=\; \vec{x} - \sum_{i=0}^{L-1} \gamma_i \vec{s}_i \qquad (4)$$

$$\vec{r}_S \;=\; \vec{r} - \sum_{i=0}^{L-1} \delta_i \vec{s}_i \qquad (5)$$

Hierin sind:

$\vec{x}$ = Meßvektor; beinhaltet die gemessene Zeitreihe eines Voxels

L = Anzahl der Detrending-Vektoren

$\gamma_i$ = Koeffizienten der Detrending-Vektoren für die Berechnung von $\vec{x}_s$

$\vec{s}_i$ = Detrending-Vektoren

$\vec{r}$ = Referenz-Vektor

$\delta_1$ = Koeffizienten der Detrending-Vektoren für die Berechnung von $\vec{r}_s$

S = Detrending-Matrix mit $\vec{s}_i$ als Spaltenvektoren

$\vec{x}_s$ = Meßvektor nach Detrending

$\vec{r}_s$ = Referenzvektor nach Detrending

Durch Verknüpfung der Formeln (1), (4) und (5) wird die Formel (6) hergeleitet, die die Grundlage für die erfindungsgemäße Berechnung der Korrelationskoeffizienten, die eine gleichbleibende Sensitivität der berechneten Werte für Änderungen der Signal-Response-Form garantiert, darstellt. Der damit erhaltene Ausdruck für die Korrelation läßt sich in Abhängigkeit von Unterausdrücken formulieren, die iterativ berechenbar sind.

Um nun eine gleichbleibend hohe Sensitivität für Änderungen der Signal-Response-Form zu gewährleisten, wurde die "Sliding-Window"-Technik entwickelt, bei der die Korrelation erfindungsgemäß auf die n letzten magnetischen Resonanz-Datensätze beschränkt wird. Die Zahl n der in die Rechnung einbezogenen Datensätze ist frei wählbar. Vorzugsweise wird die Zahl n während einer Messung konstant gehalten, jedoch läßt sich unter Beibehaltung der iterativen Berechenbarkeit von ρ die Fensterbreite in jedem Zeitschritt um eins erhöhen oder erniedrigen, oder die Fensterbreite läßt sich unter entsprechend höherem Rechenaufwand beliebig variieren. Die Korrelationsberechnung umfaßt den jeweils neu hinzugekommenen Datenwert unter Verzicht auf den ältesten Datenwert, der sich in dem für die Berechnung herangezogenen Datenfenster von n Elementen befindet. Ein Datenfenster besteht immer aus n Datensätzen, die insbesondere zwei oder dreidimensional sein können, wobei n beispielsweise zwischen 10 bis 20 liegen. Die Wahl dieser Fensterbreite (= Anzahl der herangezogenen Daten) ist dem Experimentator überlassen und ist beispielsweise von der gewünschten Sensitivität für Änderungen der gemessenen neuronalen Aktivierung und der Zeit zwischen zwei Messungen abhängig.

Unter einem Datenwert im Sinne der Erfindung ist eine einzelne Zahl, wie ein Ganzzahlenwert oder ein Fließkommawert zu verstehen, der in einem Zeitpunkt gemessen wird. Ein Datenwert ist einem Voxel zugeordnet. Ein Datensatz ist eine Ansammlung von Datenwerten, die zu einem Meßzeitpunkt gehören. Ein Datensatz umfaßt die Datenwerte aller Voxel oder eine Teilmenge aller Voxel. Ein Datensatz kann auch eine oder mehrere Schichten umfassen.

In dem von R.W. Cox verwendeten Verfahren erfolgt die Korrelationsanalyse ausschließlich kumulativ, das heißt alle seit Messungsbeginn aufgenommenen Datensätze gehen in die Korrelationsberechnung ein. Dies hat zur Folge, daß sich Abweichungen der Messignale von der Modellfunktion nach diesem Stand der Technik umso weniger auf die Korrelationskoeffitienten auswirken, je später sie auftreten. Demgegenüber hat die erfindungsgemäße Sliding-Window- Technik eine gleichbleibende Sensitivität für die Änderung der Signal-Response-Form. Während der anfänglichen Auffüllphase entspricht die Sliding-Window - Methode einer kumulativen Korrelation. Danach schließt sich die Phase des "stationären Gleichgewichts" (das heißt die Anzahl der Datenwerte n bleibt konstant, wobei mit fortschreitender Messung der jeweils älteste Datenwert entfällt und der jüngste Datenwert hinzugefügt wird) an, die wie beim Cox-Algorithmus einen bei jedem Zeitschritt konstanten Rechenaufwand aufweist.

Der zur Durchführung des Sliding-Window-Verfahrens erarbeitete Algorithmus ist in der allgemeinen Formel (6) dargestellt:

$$\rho = \frac{\vec{x}\vec{r} - \Sigma_i\delta_i\vec{x}\vec{s}_i}{\sqrt{h_1 h_2}} \qquad (6)$$

In Formel (6) sind:

$\vec{x}$ = Meßvektor
$\vec{r}$ = Referenzvektor
i = Index-Variable, die über N Datensätze läuft
$\delta_i$ = Koeffizienten der Detrending-vektoren für die Berechnung von $\vec{r}_s$
$\vec{s}_i$ = Detrending-Vektoren

$h_1$ und $h_2$ sind in den Formeln (7) und (8) definiert:

$$h_1 \;=\; \vec{x}^2 - 2\sum_i \gamma_i\vec{x}\vec{s}_i + 2\sum_{i>j} \gamma_i\gamma_j\vec{s}_i\vec{s}_j + \sum_i \gamma_i^2\vec{s}_i^{\,2} \qquad (7)$$

$$h_2 \;=\; \vec{r}^2 - 2\sum_i \delta_i\vec{r}\vec{s}_i + 2\sum_{i>j} \delta_i\delta_j\vec{s}_i\vec{s}_j + \sum_i \delta_i^2\vec{s}_i^{\,2} \qquad (8)$$

Hierin sind:

$\gamma_i, \gamma_j$ = Detrending-Koeffizienten für die Berechnung von $\vec{x}_s$
$\vec{s}_i$ = Detrending-Vektoren
S = Detrending-Matrix, die die $\vec{s}_j$ als Spaltenvektoren beinhaltet.

In einer spezielleren Formulierung ergibt sich ρ nach Formel (9).

$$\rho = \frac{a - b\frac{c}{N}}{\sqrt{d - \frac{b^2}{N}}\sqrt{e - \frac{c^2}{N}}} \qquad (9)$$

In Formel (9) ist:

N = Anzahl der Meßpunkte im Meßfenster oder die Anzahl aller Meßpunkte (insbesondere der Anfangsphase der Korrelationsberechnung)

In den Gleichungen (10) bis (14) sind a, b, c, d und e wie folgt definiert:

$$a = \sum_i x_i r_i \qquad (10)$$

$$b = \sum_i r_i = N\bar{r} \qquad (11)$$

$$c = \sum_i x_i = N\bar{x} \qquad (12)$$

$$d = \sum_i r_i^2 \qquad (13)$$

$$e = \sum_i x_i^2 \qquad (14)$$

Hierin sind:

$\vec{x}$ = Mittelwert über N gemessene Werte.
$\vec{r}$ = Mittelwert über N Komponenten des Referenz-Vektors
$r_i$ = Komponenten des Referenzvektors.
$x_i$ = Komponenten des Meßvektors.

Die in die Korrelationsberechnung eingehenden Datensätze für die Gleichungen (6) und (9) sowie (1) können in Abhängigkeit von ihrer Indexnummer gewichtet werden.

Die Rechenzeit für ein Korrelationsbild hängt nach dem erfindungsgemäßen Algorithmus der Formel (6) nicht von der Fensterbreite, also der Zahl n (N kann eine beliebige Anzahl von Datenwerten oder Datensätzen angeben; für den Fall, daß das Sliding-Window-Verfahren Anwendung findet, ist für den stationären Fall N=n) ab. Falls es eine Verschiebung zwischen Meß- und Detrending-Vektor gibt, kann das Skalarprodukt zwischen den Vektoren nicht mehr iterativ berechnet werden. Daraus folgt, daß die Detrending-Vektoren nicht mehr konstant sein können, sondern, als Sliding-Windows über vorgegebene Zahlenfolgen geschoben werden müssen.

Für die Detrending-Vektoren kann folgende Wahl getroffen werden:

Die Detrending-Vektoren seien die Vektoren mit den Elementen $t^i$, wobei i die L Detrending-Vektoren numeriert und t von der kleinsten bis zur größten Index-Nummer aller für die Korrelation berücksichtigten Magnet Resonanzdatensätze läuft. Diese Detrending-Vektoren bezeichnet man als polynomial. Die Folgen $t^i$ sind monoton wachsend. Dieses führt, von kleinen Fluktuationen abgesehen, zu einer generellen Abnahme der Detrending-Koeffizienten im Verlauf der Messung, weil sie den Anstieg der Folgen kompensieren müssen. Eine direkte Darstellung der Detrending-Koeffizienten wäre damit bedeutungslos. Unabhängig vom durchgeführten Experiment würde man immer einen ähnlichen Abfall der Detrending-Koeffizienten während der Messung beobachten. Diese Koeffizienten würden schwer zu interpretierende Informationen über die zeitliche Schwankung der Störanteile geben.

Im vorliegenden Fall lassen sich die Koeffizienten nach Formel (15) leicht in die Werte $\tilde{\gamma}_\kappa$ transformieren, die man mit einem Satz konstanter Detrending-Vektoren erhielte:

$$\tilde{\gamma}_k = \sum_{i \geq k}^{L-1} \gamma_i \begin{pmatrix} i \\ k \end{pmatrix} t_0^{i-k}, \qquad (15)$$

Hierin sind:

$\tilde{\gamma}_k$ = Die korrigierten $\gamma$-Koeffizienten

L = Anzahl der Detrending-Vektoren

i = Index-Variable

k = Index-Variable

$t_0$ = Ursprung des Sliding-Windows relativ zum Beginn der Messung

$\gamma_i$ = unkorrigierte $\gamma$-Koeffizienten

wobei der Index $t_0$ der Index des ältesten Datensatzes im Fenster (Buffer) ist.

Die Matrixmultiplikation wird auf den Vektor mit den Detrendingkoeffizienten in jedem Voxel zu jedem Zeitschritt angewendet. Der Rechenaufwand für die Korrektur der Detrending-Koeffizienten ist typischerweise kleiner als der für die eigentliche Korrelation. Die nachträgliche lineare Transformation der Detrending-Koeffizienten, die durch die linearen Gleichungssysteme bestimmt wurden, sind erforderlich, um aus den Koeffizienten eine Zusatzinformation zu den Korrelationskoeffizienten zu erhalten. Die Zusatzinformation besteht aus Angaben zur Stärke der einzelnen Störanteile.

Für den Fall nicht-polynomialer Detrendingvektoren können entsprechende Formeln hergeleitet werden. Durch Taylor-Entwicklung der Funktionen, die nichtpolynomialen Detrending-Vektoren zugrundeliegen, kann der allgemeinere Fall auf den Fall polynomialer Detrending-Vektoren zurückgeführt werden.

Die Korrelationsergebnisse hängen entscheidend von der Wahl des Referenzvektors ab. Ausgehend von einem Referenzvektor, der zumindest für einige Bildpunkte (Pixel) einen Korrelationswert liefert, der oberhalb eines bestimmten Schwellenwertes liegt (z.B. 0,5), kann eine iterative Verbesserung durchgeführt werden. Dazu wird durch komponentenweise Mittelung der Zeitreihen, deren Korrelationswert oberhalb der Schwelle liegt, ein Vektor generiert, der als Referenzvektor für eine erneute Korrelationsberechnung verwendet wird. Die mathematische Formulierung dieser Vorgehensweise ist in Formel (16) gegeben.

$$r_i = \frac{\sum_{\forall pixels(k,l) \wedge \rho(k,l) > t} x_{i,k,l}}{\sum_{\forall pixels(k,l) \wedge \rho(k,l) > t} 1} \qquad (16)$$

Hierin sind:

k,l = Pixel-Koordinaten

$\rho$ = Korrelationskoeffizient

t = Korrelationsschwellwert (kann zwischen -1 und 1 liegen und muß von den Korrelationswerten überschritten werden, damit der zugehörige Meßvektor in der Summe berücksichtigt wird.)

$r_i$ = i-te Komponente des Referenzvektors

$x_{i,k,l}$ = i-te Komponente der Zeitreihe des Pixels mit den Koordinaten k,l

Mit dem neuen Referenzvektor wird eine erneute Korrelationsberechnung durchgeführt. Diese Prozedur, die die Berechnung des neuen Referenzvektors und der Korrelationskoeffizienten umfaßt, und als ein Iterationsschritt aufgefaßt wird, kann mehrfach wiederholt werden, wodurch der Referenzvektor optimiert wird: Es werden wiederum die Zeitreihen für die Erzeugung des Referenzvektors gemittelt, deren jeweiliger Korrelationskoeffizient oberhalb des vorgegebenen Schwellwertes t liegt. Die Optimierung erfolgt durch die Anpassung des Referenzvektors an die Zeitreihen, die die höchsten Korrelationskoeffizienten aufweisen. Der Schwellwert kann von Iterationsschritt zu Iterationsschritt variiert werden, um zum Beispiel die Auswahl der zu mittelnden Zeitreihen einzuschränken. Die Prozedur kann auch auf Teilbereiche angewendet werden, für die jeweils ein eigener Referenzvektor existiert.

Evaluierung des erfindungsgemäßen Verfahrens:

Im stationären Gleichgewicht beträgt die Rechenzeit auf einer SUN Ultra Sparc 1 (143 MHz) für ein Korrelationsbild mit einer Matrixgröße von 64 X 64 Pixeln und einem Detrending-Vektor mit identischen Einträgen 0,13s. Zusammen mit der Zeit, benötigt für die Skalierung des Original- und des Korrelationsbildes auf 256 x 256 Pixels mittels bi-linearer Interpolation, ergab sich eine Rate von 2 fps (frames per second). Die Implementierungen der erfindungsgemäßen Algorithmen wurden mit dem Korrelationsmodul des AFNI (Analysis of Functional Neuroimages)- Softwarepaketes bezüglich seiner Geschwindigkeit verglichen , welches laut Programmbeschreibung auf dem in der Veröffentlichung von Cox, R.W., Jesmanowicz, A., Hyde, J.S., Magn. Reson. Med., 33, 230, 1995 beschriebenen Algorithmus basiert. Das Softwarepaket ist in der Veröffentlichung von Cox, R.W. Comput. Biomed. Res. 29,162, 1996 beschrieben. Es wurden vergleichbare Rechenzeiten ermittelt. (Aufgrund der fehlenden Sliding-Window-Fähigkeit von AFNI haben die Vergleiche jedoch nur begrenzten Wert.) Beim Geschwindigkeitstest der von der Anmelderin entwickelten Realtime-Software wird die Korrelation nur mit einem Referenzvektor durchgeführt, der während einer Messung konstant ist, dies ist aber keine prinzipielle Beschränkung. Die Berechnung wurde ferner mit nur einem Detrending-Vektor mit konstanten Elementen durchgeführt.

Zusammenfassend kann gesagt werden, daß der mit dem erfindungsgemäßen Algorithmus ausgestattete Computer in vergleichbarer Rechenzeit bessere Ergebnisse liefert. Die erfindungsgemäße Arbeitsweise des Computers ist nicht auf Echtzeitmessungen beschränkt, es können beispielsweise auch Meßwerte herangezogen werden, die auf Datenträgern gespeichert sind.

Es können auch Datenwerte und Datansätze aus kernmagnetischen Resonanzspektrokopiemessungen mit dem Erfindungsgemäßen Computer ausgewertet werden; somit soll - unter dem Begriff Kernspintomograph auch jedes kernmagnetische Resonanzspekrometer zu verstehen sein. Erfindungsgemäß ist der Computer mit Mitteln zur Auswertung ausgestattet, die nach den Formeln (2), (3) sowie (6) bis (16) oder deren mathematisch äquivalenten Ausdrükken arbeiten. Diese Mittel können Chips beziehungsweise integrierte Schaltungen, also insbesondere Prozessoren oder progammierbare Logikbausteine sein.

Mit dem erfindungsgemäßen Computer und dem mit dem Computer arbeitenden Kernspintomographen können auch eine Schlaganfallgefährdung von Patienten ermittelt werden, so daß wichtige Entscheidungen im Vorfeld von medizinischen Operationen getroffen werden können. Zusätzlich kann eine Therapie- bzw. Operationsplanung bei Schlaganfallpatienten durchgeführt bzw. unterstützt werden. Weiterhin kann die Durchblutung von sämtlichen Organen festgestellt werden.

Die wesentlichen Schritte der Arbeitsweise des erfindungsgemäßen Computers sowie des Kernmagnetischen Resonanztomographen sind hier in Kürze nochmals dargestellt:

Zunächst wird die Anzahl der Detrending-Vektoren L unddie Fensterbreite n festgelegt. Es wird Speicher für die benötigten Hilfsvariablen der Gleichungen (2),(3) und (6) bzw. der Geichung (9) belegt. Dabei werden die korrekten Initialisierungswerte festgelegt. Sowohl bei Gleichung (6) als auch Gleichung (9) ist zwischen dem ‚Auffüll-'(kumulative Korrelation am Anfang der Berechnung) und dem ‚Schon-voll-' Modus (stationärer Zustand) zu unterscheiden.

Im ersten Fall werden zu den Hilfsvariablen (in Gleichung(9) sind a, b, c, d und e die Hilfsvariablen; in Gleichung(6) ist jeder Summe eine Hilfsvariable zugeordnet) nur Zahlen hinzuaddiert, im letzteren werden zusätzlich Werte subtrahiert.

Bei Anwendung von Gleichung (6) sind die Detrending-Koeffizienten mit den Formeln (2) und (3) zu berechnen. Die Matrix der Gleichungssysteme (Dimension: L x L) und die Vektoren auf der rechten Seite des Gleichheitszeichens können mit jedem Zeitschritt iterativ aktualisiert werden. Nach Aktualisierung der Hilfsvariablen von Gleichung (6) kann der Korrelationskoeffizient nach Formel (6) berechnet werden. Die Auswertung der Formel (9) erfolgt analog. Hierbei finden Gleichungen (2) und (3) keine Anwendung. In den Beispielen wird die Korrelationsberechnung für einen einzelnen Korrelationswert demonstriert, wobei drei polynomiale Detrending-Vektoren gewählt wurden (t^0, t^1, t^2). Im ersten Beispiel stammen Referenz- und Meß-Vektor aus einem realen Experiment, im zweiten Fall wurden sie per Zufall erzeugt.

Im Folgenden sind die Rechenbeispiele 1 und 2 angegeben:

Beispiel 1                  KONTROLL

| Referenz-Vektor ( r ) | Mess-Vektor ( x ) | Detrending-Vektor1 (d1) | Detrending-Vektor2 (d2) | Detrending-Vektor3 (d3) | xi*d1i | xi*d2i |
|---|---|---|---|---|---|---|
| -1 | 820 | 1 | 0 | 0 | 820 | 0 |
| 1 | 840 | 1 | 0,04166667 | 0,00173611 | 840 | 35 |
| 1 | 804 | 1 | 0,08333333 | 0,00694444 | 804 | 67 |
| 1 | 841 | 1 | 0,125 | 0,015625 | 841 | 105,125 |
| -1 | 837 | 1 | 0,16666667 | 0,02777778 | 837 | 139,5 |
| -1 | 863 | 1 | 0,20833333 | 0,04340278 | 863 | 179,791667 |
| -1 | 867 | 1 | 0,25 | 0,0625 | 867 | 216,75 |
| -1 | 835 | 1 | 0,29166667 | 0,08506944 | 835 | 243,541667 |
| -1 | 827 | 1 | 0,33333333 | 0,11111111 | 827 | 275,666667 |
| -1 | 817 | 1 | 0,375 | 0,140625 | 817 | 306,375 |
|  |  |  |  |  | 8351 | 1568,75 |
|  | Matrix A |  |  |  |  |  |
|  | 10 | 1,875 | 0,49479167 |  |  |  |
|  | 1,875 | 0,49479167 | 0,14648438 |  |  |  |
|  | 0,49479167 | 0,14648438 | 0,04621492 |  |  |  |
| 0,0022794 | inverse A |  |  |  |  |  |
|  | 0,61818182 | -6,2181818 | 13,0909091 |  |  |  |
|  | -6,2181818 | 95,3454545 | -235,63636 |  |  |  |
|  | 13,0909091 | -235,63636 | 628,363636 |  |  |  |
|  | Vektor b | gamma |  |  |  |  |
|  | 8351 | 812,754545 |  |  |  |  |
|  | 1568,75 | 353,509091 |  |  |  |  |
|  | 412,888889 | -888 |  |  |  |  |
|  | Vektor d | delta |  |  |  |  |
|  | -4 | 0,23636364 |  |  |  |  |
|  | -1,375 | -1,0909091 |  |  |  |  |
|  | -0,4461806 | -8,7272727 |  |  |  |  |
|  | rho |  |  |  |  |  |
|  | -0,3687532 |  |  |  |  |  |

10

## KONTROLL

| xi*d3i | ri*dli | ri*d2i | ri*d3i | A11 | A12 | A22 |
|---|---|---|---|---|---|---|
| 0 | -1 | 0 | 0 | 1 | 0 | 0 |
| 1,45833333 | 1 | 0,04166667 | 0,00173611 | 1 | 0,04166667 | 0,00173611 |
| 5,58333333 | 1 | 0,08333333 | 0,00694444 | 1 | 0,08333333 | 0,00694444 |
| 13,140625 | 1 | 0,125 | 0,015625 | 1 | 0,125 | 0,015625 |
| 23,25 | -1 | -0,1666667 | -0,0277778 | 1 | 0,16666667 | 0,02777778 |
| 37,4565972 | -1 | -0,2083333 | -0,0434028 | 1 | 0,20833333 | 0,04340278 |
| 54,1875 | -1 | -0,25 | -0,0625 | 1 | 0,25 | 0,0625 |
| 71,0329861 | -1 | -0,2916667 | -0,0850694 | 1 | 0,29166667 | 0,08506944 |
| 91,8888889 | -1 | -0,3333333 | -0,1111111 | 1 | 0,33333333 | 0,11111111 |
| 114,890625 | -1 | -0,375 | -0,140625 | 1 | 0,375 | 0,140625 |
| 412,888889 | -4 | -1,375 | -0,4461806 | 10 | 1,875 | 0,49479167 |

KONTROLL

| A13 | A23 | A33 | Projektion von x | | Projektion von r | |
|---|---|---|---|---|---|---|
| | | | Px | (Pxi)^2 | Pr | (Pri)^2 |
| 0 | 0 | 0 | 7,24545455 | 52.4966116 | -1,2363636 | 1,52859504 |
| 0,00173611 | 7,2338E-05 | 3,0141E-06 | 14,0575758 | 197,615436 | 0,82424242 | 0,67937557 |
| 0,00694444 | 0,0005787 | 4,8225E-05 | -32,04697 | 1027,00827 | 0,91515152 | 0,8375023 |
| 0,015625 | 0,00195313 | 0,00024414 | -2,0681818 | 4,27737603 | 1,03636364 | 1,07404959 |
| 0,02777778 | 0,00462963 | 0,0007716 | -10,006061 | 100,121249 | -0,8121212 | 0,65954086 |
| 0,04340278 | 0,00904225 | 0,0018838 | 15,1393939 | 229,201249 | -0,630303 | 0,39728191 |
| 0,0625 | 0,015625 | 0,00390625 | 21,3681818 | 456,599194 | -0,4181818 | 0,17487603 |
| 0,08506944 | 0,02481192 | 0,00723681 | -5,319697 | 28,2991758 | -0,1757576 | 0,03089073 |
| 0,11111111 | 0,03703704 | 0,01234568 | -4,9242424 | 24,2481635 | 0,0969697 | 0,00940312 |
| 0,140625 | 0,05273438 | 0,01977539 | -3,4454545 | 11,871157 | 0,4 | 0,16 |
| 0,49479167 | 0,14648438 | 0,04621492 | | 46.170747 | | 2,35616535 |

KONTROLL

| rpx |
| --- |
| -7,2454545 |
| 14,0575758 |
| -32,04697 |
| -2,0681818 |
| 10,0060606 |
| -15,139394 |
| -21,368182 |
| 5,31969697 |
| 4,92424242 |
| 3,44545455 |
| -40,115152 |
| |
| |
| |
| |
| |
| |
| |
| |
| |
| |
| |
| |
| |
| |

**Beispiel 2**     KONTROLL

| Referenz-Vektor ( r ) | Mess-vektor ( x ) | Detrending-Vektor1 (d1) | Detrending-Vektor2 (d2) | Detrending-Vektor3 (d3) | xi*d1i | xi*d2i |
|---|---|---|---|---|---|---|
| -0,0901696 | 0,86687368 | 1 | 0 | 0 | 0,86687368 | 0 |
| -0,8732171 | -0,0109559 | 1 | 0,04166667 | 0,00173611 | -0,0109559 | -0,0004565 |
| 0,55787935 | 0,82458951 | 1 | 0,08333333 | 0,00694444 | 0,82458951 | 0,06871579 |
| -0,64421 | 0,71624441 | 1 | 0,125 | 0,015625 | 0,71624441 | 0,08953055 |
| -0,3638101 | 0,65897313 | 1 | 0,16666667 | 0,02777778 | 0,65897313 | 0,10982886 |
| -0,5565415 | 0,19779154 | 1 | 0,20833333 | 0,04340278 | 0,19779154 | 0,04120657 |
| 0,62847406 | 0,93335457 | 1 | 0,25 | 0,0625 | 0,93335457 | 0,23333864 |
| 0,6663485 | 0,89791033 | 1 | 0,29166667 | 0,08506944 | 0,89791033 | 0,26189051 |
| 0,63126889 | 0,80000471 | 1 | 0,33333333 | 0,11111111 | 0,80000471 | 0,26666824 |
| 0,11439662 | -0,7310715 | 1 | 0,375 | 0,140625 | -0,7310715 | -0,2741518 |
| -0,0881377 | 0,5695818 | 1 | 0,41666667 | 0,17361111 | 0,5695818 | 0,23732575 |
| 0,82245743 | 0,28549038 | 1 | 0,45833333 | 0,21006944 | 0,28549038 | 0,13084976 |
| -0,2228839 | 0,22365164 | 1 | 0,5 | 0,25 | 0,22365164 | 0,11182582 |
| -0,520496 | 0,90538431 | 1 | 0,54166667 | 0,29340278 | 0,90538431 | 0,4904165 |
| 0,63183051 | 0,20197755 | 1 | 0,58333333 | 0,34027778 | 0,20197755 | 0,11782024 |
| -0,3699006 | 0,0441816 | 1 | 0,625 | 0,390625 | 0,0441816 | 0,0276135 |
| -0,3707666 | 0,33015254 | 1 | 0,66666667 | 0,44444444 | 0,33015254 | 0,2201017 |
| -0,8766027 | 0,85078584 | 1 | 0,70833333 | 0,50173611 | 0,85078584 | 0,60263997 |
| -0,6929535 | -0,0096465 | 1 | 0,75 | 0,5625 | -0,0096465 | -0,0072348 |
| 0,92588962 | -0,3152563 | 1 | 0,79166667 | 0,62673611 | -0,3152563 | -0,2495779 |
| -0,4154246 | 0,29096348 | 1 | 0,83333333 | 0,69444444 | 0,29096348 | 0,24246957 |
| 0,53772851 | -0,0250258 | 1 | 0,875 | 0,765625 | -0,0250258 | -0,0218975 |
| -0,5456474 | 0,644561 | 1 | 0,91666667 | 0,84027778 | 0,644561 | 0,59084758 |
| -0,3807277 | 0,65621669 | 1 | 0,95833333 | 0,91840278 | 0,65621669 | 0,62887433 |
| | | | | | 9,8067328 | 3,9186453 |
| | Matrix A | | | | | |
| | 24 | 11,5 | 7,50694444 | | | |
| | 11,5 | 7,50694444 | 5,51041667 | | | |
| | 7,50694444 | 5,51041667 | 4,31388648 | | | |
| 6,33350681 | inverse A | | | | | |
| | 0,31884615 | -1,3015385 | 1,10769231 | | | |
| | -1,3015385 | 7,44912131 | -7,2503497 | | | |
| | 1,10769231 | -7,2503497 | 7,56558224 | | | |
| | Vektor b | gamma | | | | |
| | 9,80673281 | 0,71689642 | | | | |
| | 3,9186453 | -1,1827754 | | | | |
| | 2,42876559 | 0,82631973 | | | | |
| | Vektor d | delta | | | | |
| | -1,4952156 | -0,2761552 | | | | |
| | -0,9535108 | 1,65343167 | | | | |
| | -0,9392883 | -1,8492151 | | | | |
| | rho | | | | | |
| | -0,0381978 | | | | | |

## KONTROLL

| xi*d3i | ri*d1i | ri*d2i | ri*d3i | A11 | A12 | A22 |
|---|---|---|---|---|---|---|
| 0 | -0,0901696 | 0 | 0 | 1 | 0 | 0 |
| -1,902E-05 | -0,8732171 | -0,036384 | -0,001516 | 1 | 0,04166667 | 0,00173611 |
| 0,00572632 | 0,55787935 | 0,04648995 | 0,00387416 | 1 | 0,08333333 | 0,00694444 |
| 0,01119132 | -0,64421 | -0,0805263 | -0,0100658 | 1 | 0,125 | 0,015625 |
| 0,01830481 | -0,3638101 | -0,060635 | -0,0101058 | 1 | 0,16666667 | 0,02777778 |
| 0,0085847 | -0,5565415 | -0,1159461 | -0,0241554 | 1 | 0,20833333 | 0,04340278 |
| 0,05833466 | 0,62847406 | 0,15711851 | 0,03927963 | 1 | 0,25 | 0,0625 |
| 0,07638473 | 0,6663485 | 0,19435165 | 0,0566859 | 1 | 0,29166667 | 0,08506944 |
| 0,08888941 | 0,63126889 | 0,21042296 | 0,07014099 | 1 | 0,33333333 | 0,11111111 |
| -0,1028069 | 0,11439662 | 0,04289873 | 0,01608702 | 1 | 0,375 | 0,140625 |
| 0,09888573 | -0,0881377 | -0,036724 | -0,0153017 | 1 | 0,41666667 | 0,17361111 |
| 0,05997281 | 0,82245743 | 0,37695966 | 0,17277318 | 1 | 0,45833333 | 0,21006944 |
| 0,05591291 | -0,2228839 | -0,111442 | -0,055721 | 1 | 0,5 | 0,25 |
| 0,26564227 | -0,520496 | -0,2819353 | -0,152715 | 1 | 0,54166667 | 0,29340278 |
| 0,06872847 | 0,63183051 | 0,3685678 | 0,21499788 | 1 | 0,58333333 | 0,34027778 |
| 0,01725844 | -0,3699006 | -0,2311879 | -0,1444924 | 1 | 0,625 | 0,390625 |
| 0,14673446 | -0,3707666 | -0,2471778 | -0,1647852 | 1 | 0,66666667 | 0,44444444 |
| 0,42686998 | -0,8766027 | -0,6209269 | -0,4398233 | 1 | 0,70833333 | 0,50173611 |
| -0,0054261 | -0,6929535 | -0,5197152 | -0,3897864 | 1 | 0,75 | 0,5625 |
| -0,1975825 | 0,92588962 | 0,73299595 | 0,58028846 | 1 | 0,79166667 | 0,62673611 |
| 0,20205797 | -0,4154246 | -0,3461872 | -0,2884893 | 1 | 0,83333333 | 0,69444444 |
| -0,0191604 | 0,53772851 | 0,47051245 | 0,41169839 | 1 | 0,875 | 0,765625 |
| 0,54161028 | -0,5456474 | -0,5001768 | -0,4584954 | 1 | 0,91666667 | 0,84027778 |
| 0,60267123 | -0,3807277 | -0,364864 | -0,3496613 | 1 | 0,95833333 | 0,91840278 |
| 2,42876559 | -1,4952156 | -0,9535108 | -0,9392883 | 24 | 11,5 | 7,50694444 |

KONTROLL

| A13 | A23 | A33 | Projektion von x | | Projektion von r | |
|---|---|---|---|---|---|---|
| | | | Px | (Pxi)^2 | Pr | (Pri)^2 |
| 0 | 0 | 0 | 0,14997725 | 0,02249318 | 0,18598558 | 0,03459064 |
| 0,00173611 | 7,2338E-05 | 3,0141E-06 | -0,6800046 | 0,46240627 | -0,6627444 | 0,43923015 |
| 0,00694444 | 0,0005787 | 4,8225E-05 | 0,20051938 | 0,04020802 | 0,70909035 | 0,50280912 |
| 0,015625 | 0,00195313 | 0,00024414 | 0,13428367 | 0,0180321 | -0,5458398 | 0,29794107 |
| 0,02777778 | 0,00462963 | 0,0007716 | 0,11625262 | 0,01351467 | -0,3118598 | 0,09725652 |
| 0,04340278 | 0,00904225 | 0,0018838 | -0,3085579 | 0,09520798 | -0,5445902 | 0,29657846 |
| 0,0625 | 0,015625 | 0,00390625 | 0,46050703 | 0,21206672 | 0,60684728 | 0,36826362 |
| 0,08506944 | 0,02481192 | 0,00723681 | 0,45569552 | 0,20765841 | 0,61756449 | 0,3813859 |
| 0,11111111 | 0,03703704 | 0,01234568 | 0,38555347 | 0,14865148 | 0,56174854 | 0,31556142 |
| 0,140625 | 0,05273438 | 0,01977539 | -1,1206283 | 1,25580785 | 0,03056081 | 0,00093396 |
| 0,17361111 | 0,07233796 | 0,03014082 | 0,20205019 | 0,04082428 | -0,1798681 | 0,03235252 |
| 0,21006944 | 0,09628183 | 0,04412917 | -0,0628852 | 0,00395454 | 0,72925337 | 0,53181048 |
| 0,25 | 0,125 | 0,0625 | -0,108437 | 0,01175858 | -0,3111408 | 0,0968086 |
| 0,29340278 | 0,1589265 | 0,08608519 | 0,58671342 | 0,34423264 | -0,5973847 | 0,35686852 |
| 0,34027778 | 0,19849537 | 0,11578897 | -0,1061448 | 0,01126671 | 0,57273071 | 0,32802046 |
| 0,390625 | 0,24414063 | 0,15258789 | -0,2562613 | 0,06566986 | -0,4047905 | 0,16385536 |
| 0,44444444 | 0,2962963 | 0,19753086 | 0,03451987 | 0,00119162 | -0,3750259 | 0,14064439 |
| 0,50173611 | 0,35539641 | 0,25173913 | 0,55709424 | 0,31035399 | -0,8438103 | 0,71201586 |
| 0,5625 | 0,421875 | 0,31640625 | -0,3042661 | 0,09257789 | -0,6166886 | 0,38030483 |
| 0,62673611 | 0,49616609 | 0,39279815 | -0,6136732 | 0,37659479 | 1,05204796 | 1,10680491 |
| 0,69444444 | 0,5787037 | 0,48225309 | -0,0141199 | 0,00019937 | -0,232952 | 0,05426662 |
| 0,765625 | 0,66992187 | 0,58618164 | -0,3396447 | 0,11535854 | 0,78293631 | 0,61298927 |
| 0,84027778 | 0,77025463 | 0,70606674 | 0,3175373 | 0,10082993 | -0,2312836 | 0,05349209 |
| 0,91840278 | 0,880136 | 0,84346366 | 0,31391907 | 0,09854518 | 0,00921315 | 8,4882E-05 |
| 7,50694444 | 5,51041667 | 4,31388648 | | 2,01231325 | | 2,70275224 |

KONTROLL

| rpx |
| --- |
| -0,0135234 |
| 0,59379163 |
| 0,11186562 |
| -0,0865069 |
| -0,0422939 |
| 0,17172528 |
| 0,28941672 |
| 0.30365202 |
| 0.24338791 |
| -0.1281961 |
| -0,0178082 |
| -0.0517204 |
| 0.02416886 |
| -0,305382 |
| -0,0670655 |
| 0,0947912 |
| -0,0127988 |
| -0.4883503 |
| 0.21084231 |
| -0,5681936 |
| 0,00586575 |
| -0,1826366 |
| -0.1732634 |
| -0.1195177 |
| -0.2077495 |

**Patentansprüche**

1. Computer zur Auswertung von Daten von Kernspintomographen, bei der eine Korrelationsanalyse mit einem Detrending-Verfahren erfolgt, **gekennzeichnet durch**

   - Mittel zur Auswertung, die nach einem Sliding-Window-Verfahren eine Anzahl von n Datenwerten zur Korrelationsanalyse heranziehen, wobei mit Fortschreiten der Datenmessung der jeweils älteste Wert oder die ältesten Werte entfallen und der jüngste Datenwert oder die jüngsten Datenwerte zur Berechnung herangezogen werden und
   - Mittel zur Berechnung der Korrelationskoeffizienten $\rho$ gemäß Formel (1)

$$\rho = \frac{\vec{x}_s \vec{r}_s}{|\vec{x}_s||\vec{r}_s|} \tag{1}$$

mit

$\vec{x}_s =$ Messvektor nach Detrending und
$\vec{r}_s =$ Referenzvektor nach Detrending,

wobei die Mittel zur Berechnung der Korrelationskoeffizienten weiteres enthalteln Mittel zur Berechnung

$$\vec{x}_s = \vec{x} - \sum_{i=0}^{L-1} \gamma_i \vec{s}_i \qquad \text{und} \qquad r_s = \vec{r} - \sum_{i=0}^{L-1} \delta_i \vec{s}_i$$

und Mittel zur Berechnung nach Formel (6)

$$\rho = \frac{\vec{x}\vec{r} - \Sigma_i \delta_i \vec{x}\vec{s}_i}{\sqrt{h_1 h_2}} \tag{6}$$

mit

$\vec{x} =$ Messvektor,
$\vec{r} =$ Referenzvektor,
$i =$ Index-Variable, die über N Datensätze läuft,
$\delta_i =$ Koeffizienten der Detrending-Vektoren,
$\vec{s}_i =$ Detrending-Vektoren,
$h_1 =$

$$\vec{x}^2 - 2\sum_i \gamma_i \vec{x}\vec{s}_i + 2\sum_{i>j} \gamma_i \gamma_j \vec{s}_i \vec{s}_j + \sum_i \gamma_i^2 \vec{s}_i^2 \qquad ,$$

$h_2 =$

$$\vec{r}^2 - 2\sum_i \delta_i \vec{r}\vec{s}_i + 2\sum_{i>j} \delta_i \delta_j \vec{s}_i \vec{s}_j + \sum_i \delta_i^2 \vec{s}_i^2 \qquad ,$$

wobei

$\gamma_i, \gamma_j =$ Detrending - Koeffizienten,
$\vec{s}_j =$ Detrending-Vektoren,
$S =$ Detrending- Matrix, die die $\vec{s}_j$ als Spaltenvektoren beinhaltet,

$L =$ Anzahl der Detrending-Vektoren

arbeiten.

2. Computer nach Anspruch 1,
   **dadurch gekennzeichnet,**
   **dass** die Anzahl von n Datenwerten zur Berechnung konstant bleibt.

3. Computer nach Anspruch 1 oder 2,
   **dadurch gekennzeichnet,**
   **dass** er über Mittel zur Berechnung der Detrending-Koeffizienten in $\gamma$ und $\delta$ gemäß den Formeln (2) und (3)

$$(S^T S)\vec{\gamma} = S^T \vec{x} \tag{2}$$

$$(S^T S)\vec{\delta} = S^T \vec{r} \tag{3}$$

verfügt.

4. Computer nach einem der Ansprüche 1 bis 3,
   **dadurch gekennzeichnet,**
   **dass** er über Mittel zur Berechnung mittels eines Sliding-Window-Verfahrens nach der Formel (9)

$$\rho = \frac{a - b\dfrac{c}{N}}{\sqrt{d - \dfrac{b^2}{N}}\,\sqrt{e - \dfrac{c^2}{N}}} \tag{9}$$

mit

$$a = \sum_i x_i r_i$$

$$b = \sum_i r_i = N\bar{r}$$

$$c = \sum_i x_i = N\bar{x}$$

$$d = \sum_i r_i^{\,2}$$

$$e = \sum_i x_i^{\,2}$$

verfügt.

5. Computer nach einem der Ansprüche 1 bis 4

**dadurch gekennzeichnet,**
**dass** der Computer über Mittel zur Kompensierung eines methodenbedingten Abfalls der Detrending-Koeffizienten verfügt.

**6.** Computer nach Anspruch 5,
**dadurch gekennzeichnet,**
**dass** er Mittel zum Auswerten einer Korrektur gemäß Formel (15)

$$\widetilde{\gamma}_k = \sum_{i \ge k}^{L-1} \gamma_i \binom{i}{k} t_0^{i-k} \qquad , \qquad (15)$$

umfasst,
wobei

$\widetilde{\gamma}_k =$ die korrigierten $\gamma$-Koeffizienten
$L =$ Anzahl der Detrending-Vektoren
$i =$ Index-Variable
$k =$ Index-Variable
$t_0 =$ Ursprung des Sliding-Windows relativ zum Beginn der Messung
$\gamma_i =$ unkorigierte $\gamma$-Koeffizienten

bezeichnet, falls polynominale Detrending-Vektoren gewählt wurden.

**7.** Computer nach einem der Ansprüche 1 bis 6,
**dadurch gekennzeichnet,**
**dass** er weitere Mittel zum Auswerten aufweist, die eine Auswertung mit räumlich verschiedenen Referenzvektoren erlauben.

**8.** Computer nach Anspruch 7,
**dadurch gekennzeichnet,**
**dass** er weitere Mittel zum Auswerten aufweist, die den Referenzvektor an die Zeitreihen, die die höchsten Korrelationskoeffizienten aufweisen, anpasst.

**9.** Computer nach einem der Ansprüche 1 bis 8,
**dadurch gekennzeichnet,**
**dass** er Mittel zur Optimierung umfasst, die die Referenzvektoren ausgehend von Ausgangsvektoren optimieren.

**10.** Computer nach Anspruch 8 oder 9,
**dadurch gekennzeichnet,**
**dass** er Mittel zur Optimierung nach Formel (16)

$$r_i = \frac{\sum_{\forall\, pixels(k,l) \wedge \rho(k,l) > t} x_{i,k,l}}{\sum_{\forall\, pixels(k,l) \wedge \rho(k,l) > t} 1} \, , \qquad (16)$$

umfasst,
wobei

$k, l =$ Pixel-Koordinaten,
$\rho =$ Korrelationskoeffizient,
$t =$ Korrelationsschwellwert,
$r_i =$ i-te Komponente des Referenzvektors,
$x_{i,k,l} =$ i-te Komponente der Zeitreihe des Pixels mit den Koordinaten k,l.

**11.** Kernresonanztomograph, der einen Computer nach einem der Ansprüche 1 bis 10 aufweist.

**Claims**

**1.** computer for analysing data from nuclear magnetic resonance tomographs in which a correlation analysis is performed by a detrending method, **characterised by**

- means for analysis which, by a sliding window method, looks at a number n of data values for the correlation analysis, the value which is, or the values which are, oldest at the time being discarded as the measurement of data progresses and the value which is, or the values which are, most recent being looked at for the calculation, and
- means for calculating the correlation coefficient $\rho$ from formula (1)

$$\rho = \frac{\vec{x}_s \vec{r}_s}{|\vec{x}_s||\vec{r}_s|} \tag{1}$$

where

$\vec{x}_s =$ measurement vector after detrending and
$\vec{r}_s =$ reference vector after detrending,

the means for calculating the correlation coefficient also including means for calculating

$$\vec{x}_s = \vec{x} - \sum_{i=0}^{L-1} \gamma_i \vec{s}_i \qquad \text{and} \qquad \vec{r}_s = \vec{r} - \sum_{i=0}^{L-1} \delta_i \vec{s}_i$$

and means for calculating from formula (6)

$$\rho = \frac{\vec{x}\vec{r} - \Sigma_i \delta_i \vec{x}\vec{s}_i}{\sqrt{h_1 h_2}} \tag{6}$$

where

$\vec{x}_s =$ measurement vector,
$\vec{r}_s =$ reference vector,
$i =$ index variable which operates across N datasets,
$\delta_i =$ coefficients of the detrending vectors,
$s_i =$ detrending vectors,
$h_1 =$

$$\vec{x}^2 - 2\sum_i \gamma_i \vec{x}\vec{s}_i + 2\sum_{i>j} \gamma_i \gamma_j \vec{s}_i \vec{s}_j + \sum_i \gamma_i^2 \vec{s}_i^2 \,,$$

$h_2 =$

$$\vec{r}^2 - 2\sum_i \delta_i \vec{r}\vec{s}_i + 2\sum_{i>j} \delta_i \delta_j \vec{s}_i \vec{s}_j + \sum_i \delta_i^2 \vec{s}_i^2 \,,$$

where

$\gamma_i$ and $\gamma_j =$ detrending coefficients,
$s_j =$ detrending vectors,

S = detrending matrix which contains the $\vec{s}_j$ 's as column vectors,

L = number of detrending vectors.

2. Computer according to claim 1, **characterised in that** the number n of data values for calculation remains constant.

3. Computer according to claim 1 or 2, **characterised in that** it has means for calculating the detrending coefficients in γ and δ from formulas (2) and (3)

$$(S^T S)\vec{\gamma} = S^T \vec{x} \qquad (2)$$

$$(S^T S)\vec{\delta} = S^T \vec{r} \qquad (3).$$

4. Computer according to one of claims 1 to 3, **characterised in that** it has means for calculation by a sliding window method in accordance with formula (9)

$$\rho = \frac{a - b\dfrac{c}{N}}{\sqrt{d - \dfrac{b^2}{N}}\sqrt{e - \dfrac{c^2}{N}}} \qquad (9)$$

where

$$a = \sum_i x_i r_i$$

$$b = \sum_i r_i = N\bar{r}$$

$$c = \sum_i x_i = N\bar{x}$$

$$d = \sum_i r_i^2$$

$$e = \sum_i x_i^2 .$$

5. Computer according to one of claims 1 to 4, **characterised in that** the computer has means for compensating for a method-related decline in the detrending coefficients.

6. Computer according to claim 5, **characterised in that** it comprises means for analysing a correction in accordance with formula (15)

$$\widetilde{\gamma}_k = \sum_{i \geq k}^{L-1} \gamma_i \binom{i}{k} t_o^{i-k} \qquad (15)$$

where

$\widetilde{\gamma}_k$ = the corrected $\gamma$ coefficients
L = number of detrending vectors
i = index variable
k = index variable
$t_0$ = Origin of sliding window relative to beginning of measurement
$\gamma_i$ = uncorrected $\gamma$ coefficients,

if polynomial detrending vectors have been selected.

7. Computer according to one of claims 1 to 6, **characterised in that** it has further means for analysis which permit analysis with reference vectors which are different spatially.

8. Computer according to claim 7, **characterised in that** it has further means for analysis which adapt the reference vector to the times series which have the highest correlation coefficients.

9. Computer according to one of claims 1 to 8, **characterised in that** it comprises means for optimisation which optimise the reference vectors on the basis of starting vectors.

10. Computer according to claim 8 or 9, **characterised in that** it has means for optimisation in accordance with formula (16)

$$r_i = \frac{\sum_{\forall \, pixels(k,l) \wedge \rho(k,l) > t} x_{i,k,l}}{\sum_{\forall \, pixels(k,l) \wedge \rho(k,l) > t} 1} \qquad (16)$$

where

k, l = pixel co-ordinates,
$\rho$ = correlation coefficient,
t = correlation threshold,
$r_i$ = $i^{th}$ component of the reference vector,
$X_{i,k,l}$ = $i^{th}$ component of the time series of the pixel having the co-ordinates k, 1.

11. Nuclear resonance tomograph which has a computer according to one of claims 1 to 10.

**Revendications**

1. Ordinateur d'évaluation de données de tomographe à spin nucléaire, dans lequel on effectue une analyse de corrélation par un procédé Detrending,
    **caractérisé par**

    - des moyens d'évaluation qui tirent parti, par un procédé de Sliding-Window, d'un certain nombre de n valeurs de données pour l'analyse de corrélation, au fur et à mesure que se poursuit la mesure de données, la valeur respectivement la plus ancienne ou les valeurs les plus anciennes étant abandonnée(s) et la valeur de donnée la plus récente ou les valeurs de données les plus récentes étant mise(s) à profit pour le calcul et
    - des moyens de calcul du coefficient $\rho$ de corrélation suivant la formule (1)

$$\rho = \frac{\vec{x}_s \vec{r}_s}{|\vec{x}_s||\vec{r}_s|} \tag{1}$$

avec

$\vec{x}_s =$     vecteur de mesure suivant Detrending et
$\vec{r}_s =$     vecteur de référence suivant Detrending,

les moyens de calcul de coefficients de corrélation contenant, en outre, des moyens de calcul de

$$\vec{x}_s = \vec{x} - \sum_{i=0}^{L-1} \gamma_i \vec{s}_i \qquad \text{et} \qquad \vec{r}_s = \vec{r} - \sum_{i=0}^{L-1} \delta_i \vec{s}_i$$

$$\rho = \frac{\vec{x}\vec{r} - \Sigma_i \delta_i \vec{x}\vec{s}_i}{\sqrt{h_1 h_2}} \tag{6}$$

et des moyens de calcul suivant la formule (6)

avec

$\vec{x} =$     vecteur de mesure,
$\vec{r} =$     vecteur de référence
$i =$     variable d'indice qui s'étend sur N jeux de données,
$\delta_i =$     coefficients des vecteurs Detrending,
$\vec{s}_i =$     vecteurs Detrending,

$h_1 =$     $\bar{x}^2 - 2\sum_i \gamma_i \bar{x}\bar{s}_i + 2\sum_{i>j} \gamma_i \gamma_j \bar{s}_i \bar{s}_j + \sum_i \gamma_i^2 \bar{s}_i^2$

$h_2 =$     $\bar{r}^2 - 2\sum_i \delta_i \bar{r}\bar{s}_i + 2\sum_{i>j} \delta_i \delta_j \bar{s}_i \bar{s}_j + \sum_i \delta_i^2 \bar{s}_i^2 \quad .$

$y_i, y_j =$     coefficients Detrending,
$\vec{s}_j =$     vecteurs Detrending,
$S =$     matrice Detrending, qui comporte les $\vec{s}_j$ comme vecteurs de colonnes,
$L =$     nombre des vecteurs Detrending.

**2.** Ordinateur suivant la revendication 1,
    **caractérisé**
    **en ce que** le nombre de n valeurs de données reste constant pour le calcul.

**3.** Ordinateur suivant la revendication 1 ou 2,
    **caractérisé**
    **en ce qu'**il dispose de moyens de calcul des coefficients Detrending dans $\gamma$ et $\delta$ suivant les formules (2) et (3)

$$(S^T S)_\gamma = S^T \vec{x} \tag{2}$$

$$(S^T S)\delta = S^T \vec{r} \tag{3}.$$

**4.** Ordinateur suivant l'une des revendications 1 à 3,
    **caractérisé**

**en ce qu'**il dispose de moyens de calcul au moyen d'un procédé Sliding-Window suivant la formule (9)

$$\rho = \frac{a - b\dfrac{c}{N}}{\sqrt{d - \dfrac{b^2}{N}}\,\sqrt{e - \dfrac{c^2}{N}}} \tag{9}$$

avec

$$a = \sum_i x_i r_i$$

$$b = \sum_i r_i = N\bar{r}$$

$$c = \sum_i x_i = N\bar{x}$$

$$d = \sum_i r_i^2$$

$$e = \sum_i x_i^2$$

5. Ordinateur suivant l'une des revendications 1 à 4,
   **caractérisé**
   **en ce que** l'ordinateur dispose de moyens de compensation d'un reste dû à la méthode des coefficients Detrending.

6. Ordinateur suivant la revendication 5,
   **caractérisé**
   **en ce qu'**il comprend des moyens d'évaluation d'une correction suivant la formule (15)

$$\tilde{\gamma}_k = \sum_{i \geq k}^{L-1} \gamma_i \binom{i}{k} t_0^{\,i-k} \quad , \tag{15}$$

dans laquelle

$\tilde{y}_k$ =   les coefficients $\gamma$ corrigés
L =   nombre des vecteurs Detrending
i =   variable d'indice
k =   variable d'indice
$t_0$ =   origine de la Sliding-Window par rapport au début de la mesure
$\gamma_i$ =   coefficient de $\gamma$ non corrigé

dans le cas où des vecteurs Detrending polynomiaux ont été choisis.

**7.** Ordinateur suivant l'une des revendications 1 à 6,
   **caractérisé**
   **en ce qu'**il comprend d'autres moyens d'évaluation qui permettent une évaluation avec des vecteurs de référence différents dans l'espace.

**8.** Ordinateur suivant la revendication 7,
   **caractérisé**
   **en ce qu'**il comprend d'autres moyens d'évaluation, qui adaptent le vecteur de référence aux successions temporelles qui ont les coefficients de corrélation les plus grands.

**9.** Ordinateur suivant l'une des revendications 1 à 8,
   **caractérisé**
   **en ce qu'**il comprend des moyens d'optimisation qui optimisent les vecteurs de référence à partir de vecteurs d'origine.

**10.** Ordinateur suivant la revendication 8 ou 9,
   **caractérisé**
   **en ce qu'**il comprend des moyens d'optimisation suivant la formule (16)

$$r_i = \frac{\sum_{\forall\, pixels(k,l) \wedge \rho(k,l)>t} x_{i,k,l}}{\sum_{\forall\, pixels(k,l) \wedge \rho(k,l)>t} 1} \,, \tag{16}$$

dans laquelle

k, l =     coordonnées de pixel,
$\rho$ =     coefficient de corrélation,
t =     valeur de seuil de corrélation,
$r_i$ =     ième composant du vecteur de référence,
$x_{i,k,l}$ =     ième composant de la succession temporelle du pixel ayant les coordonnées k, l

**11.** Tomographe de résonance nucléaire qui a un ordinateur suivant l'une des revendications 1 à 10.